# EUROPEAN PATENT APPLICATION

(11) **EP 2 353 923 A2**
(43) Date of publication of application: **10.08.2011**
(21) Application number: 11152897.2
(22) Date of filing: 01.02.2011
(51) Int. Cl.: B60L 11/18

(54) **Power supply point for a vehicle**

(30) Priority: 02.02.2010 FI 20105093
(71) Applicant: Ensto Finland Oy, 06150 Porvoo (FI)
(72) Inventor: Rae, Matti, 06750, Tolkkinen (FI); Mäittälä, Atte, 07510, Vakkola (FI); Naakka, Seppo, 00780, Helsinki (FI); Keinänen, Hannu, 00690, Helsinki (FI); Laakkonen, Rauno, 06150, Porvoo (FI)
(74) Representative: Holmström, Stefan Mikael

(57) **Abstract**

This invention relates to a power supply point (1) comprising at least one power output (2), and a supply cable (5) which connects the power output to an electric network to electrify the power output (2). In order to detect power supply interference, the power supply point (1) further comprises a current detector (9) which monitors the power supply via the supply cable (5) to the power output (2), and an indicating device (10) which is responsive to the current detector (9) and which indicates a situation where the power supply goes below or exceeds a predetermined limit value.

## Description

### BACKGROUND OF THE INVENTION

This invention relates to a power supply point via power output of which power supply can be implemented, and particularly to improving reliability of such a power supply point.

### DESCRIPTION OF PRIOR ART

In areas where winters are cold, vehicles are typically provided with electric heating devices with which the vehicles can be heated before starting. To implement power supply to these electric heating devices, power supply points are arranged in connection with parking areas in order to supply power to the heating devices.

One problem relating to the solution according to the prior art is the unreliability of power supply. In practice, it is not exceptional that power supply in a parking area comprising several power supply points is interfered for instance because a fuse shuts off the power supply.

It is not possible for a consumer, i.e. usually the driver of a vehicle in the case of a vehicle, who utilizes a power supply point and has left the vehicle in the parking area and connected it to the power supply point to make sure in a simple way whether the power supply from the power supply point to the vehicle is realized in practice.

### SUMMARY OF THE INVENTION

An object of this invention is to solve the above problem and to provide a solution which makes it easier to detect power supply interference. This object is achieved with a power supply point according to independent claim 1.

Providing a power supply point with a current detector and an indicating device significantly facilitates detection of power supply interference. Then, the driver of a vehicle or, alternatively, for example the maintenance staff responsible for maintaining the power supply point can detect the interference at an early stage and thus handle the situation to eliminate the interference. The indicating device may be arranged to indicate a situation where the power supply goes below a predetermined limit value, in which case the indicating device indicates an interference situation. Alternatively, the indicating device may be arranged to indicate a situation where the power supply exceeds a predetermined limit value. The indicating device may also indicate both situations; in other words, the indicating device indicates the power supply going below the limit value in a first manner and the power supply exceeding the limit value in a second manner.

### BRIEF DESCRIPTION OF THE FIGURES

In the following, the invention will be described in greater detail, by way of example, with reference to the attached figures, of which:
Figure 1 illustrates a first embodiment of a power supply point; and
Figure 2 illustrates a second embodiment of a power supply point.

### DESCRIPTION OF AT LEAST ONE EMBODIMENT

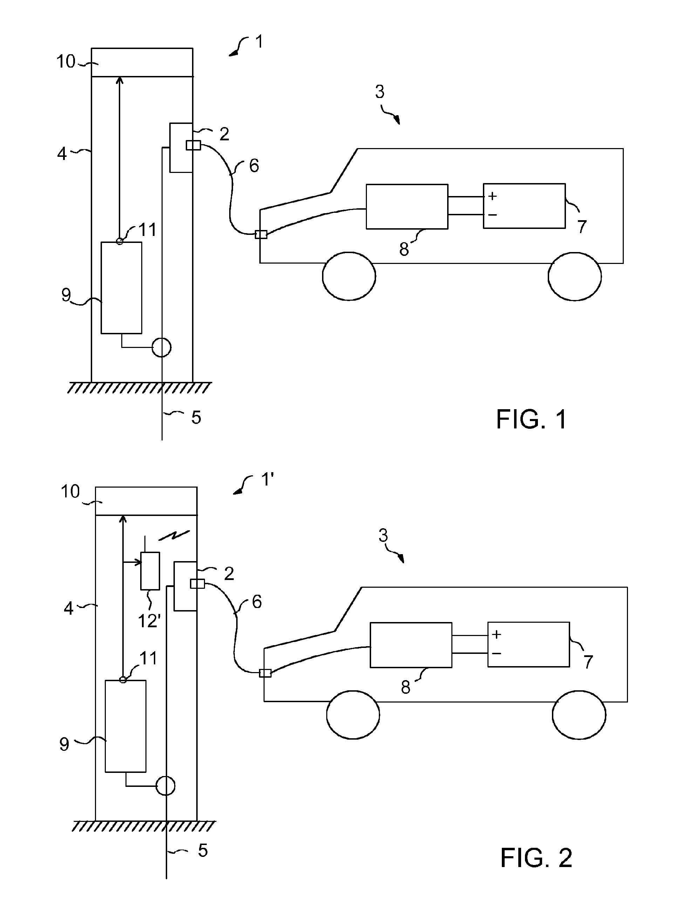

Figure 1 illustrates a first embodiment of a power supply point. In the case of Figure 1 it is assumed, by way of example, that a power supply point 1 is arranged in connection with a parking area, so that via its power output 2, power supply can be implemented to a vehicle 3 parked in the parking area. Thus, this involves a power supply point 1 whose electric parts are arranged in an outdoor installation housing 4 which protects the equipment installed in the outdoor installation housing against water and dirt. In practice, the housing may be shaped as a hollow pillar having an openable hatch protecting the power output 2.

Leading to the power output 2, there is a supply cable 5 which connects the power output to an electric network in order to electrify the power output. Power supply to the power output may be continuously on. Alternatively, the supply cable 5 may be connected to the electric network via a switching device allowing power supply to the power output for example only when the consumer has paid via an automatic payment machine for the power supply being switched on to the power supply point 1. Instead of switching it on via an automatic payment machine, the power supply may be switched on in another manner, for instance in such a way that the consumer phones a predetermined number, in which case the switching device obtains, via the telephone network, information that the power supply should be switched on, and the consumer is invoiced for switching the power supply on in connection with, for example, the telephone bill.

In the example of Figure 1 it is assumed, by way of example, that the vehicle 3 to which power supply is implemented from the power output 2 via a cable 6 is specifically an electric car or a chargeable hybrid car. In this case, a battery 7 of the electric car is charged with a charger 8 to which power supply is implemented from the power output 2. In the example 1, it is assumed that the electric output 2 is formed of a socket into which a connector at the end of the cable 6 is inserted to connect the vehicle's power-consuming equipment 8 to the power output. Alternatively, it is feasible that the power output 2 may be formed of, for instance, a cable fixedly attached to the power supply point 1, one end of the cable being connected to a connector in the vehicle 3 to switch on power to the power-consuming equipment 8.

The power supply point 1 comprises a current detector 9 which monitors power supply to the power output 2 via the supply cable 5. The current detector 9 monitors the current intensity. The current detector 9 comprises at least one outlet 11 that is, in the example of Figure 1, connected to the indicating device. In this example, the indicating device is formed of a signal light 10. The signal light is arranged to be, for example, omnidirectional in the upper part of the pillar-shaped outdoor installation housing, in which case it is easy to observe from all directions around the power supply point whether the signal light is on.

The indicating device is responsive to the current detector 9, whereby the signal light 10 may indicate a situation where power supply to the power output 2 goes below a predetermined limit value. In this case, the indicating device indicates an interference situation as an indication of the power supply not being realized in a desired manner. Alternatively, the signal light 10 functioning as the indicating device may indicate a situation where power supply to the power output 2 exceeds a predetermined limit value. In this case, the indicating device indicates that the situation is normal, in other words that the power supply is realized in a desired manner. A further alternative is that the signal light 10 indicates both the power supply exceeding the limit value and the power supply going below the limit value. Thus, the signal light may, for example, indicate an interference situation, i.e. the power supply going below the limit value, by flashing in a given manner or by a given colour, while it indicates the situation to be normal, i.e. the limit value being exceeded, by flashing in another manner or by another colour.

Owing to the indicating device formed of the signal light 10, a person in the vicinity of the power supply point 1, such as the driver of a vehicle or a person responsible for the maintenance of the power supply point, can simply and immediately detect a situation where power supply to the vehicle 3 is not, according to the signal light, realized even if the cable 6 is correctly connected between the power supply point and the vehicle.

When the batteries of an electric car or a hybrid car are to be charged, the limit value is preferably selected in such a way that it is lower than the idle running consumption of the battery charger 8 of the vehicle 3. Thus, when the battery is empty and the battery charger 8 is consuming energy to charge the battery 7, the current detector 9 detects the power supply to be at a level that exceeds the limit value. Also when the battery 7 is fully charged and the battery charger 8 is not capable of charging it any longer, the idle running consumption of the battery charger 8 alone is sufficient for the current detector 9 to detect that the power supply is at a level exceeding the limit value. If, by contrast, for instance the cable 6 is broken or disconnected or if the power supply between the electric network and the power output 2 is interrupted, the current detector 9 detects that the power supply is at a level that goes below the limit value. The limit value used depends on the practical implementation. In many cases, an appropriate result is achieved when the limit value is 10 mA or lower.

When it comes to something else than charging vehicle batteries, the limit value is selected to be suitable for the object of use. When the power-consuming equipment is formed of, for example, a block heater and/or an interior heater of a vehicle, the limit value is set to be lower than the consumption of the heaters.

The indicating device being formed of a signal light 10, one alternative is to utilize the signal light in such a way that when a power supply point is free (anyone may take it into use), this is indicated by, for example, producing green light with the signal light. When, consequently, the driver connects his/her vehicle to the power supply point and takes it into use by, for instance, paying for the use of the power supply point at an automatic machine or by phone, the signal light may turn blue to indicate that the power supply point is now available and that power supply is implemented from the power supply point to the power-consuming equipment. If the power supply goes below the limit value for some reason, the power supply point indicates this by changing the signal light back to green or, alternatively, for example by a red light.

Figure 2 illustrates a second embodiment of a power supply point 1'. The embodiment of Figure 2 corresponds, to a great extent, to the embodiment of Figure 1, due to which the embodiment of Figure 2 is explained in the following by primarily presenting differences between the embodiments.

In the embodiment of Figure 2, the indicating device of the power supply point 1' comprises not only a signal light 10 but also a communication device 12'. The communication device 12' may be connected to the same outlet 11 of the current detector 9 as the signal light, as presented in the example of Figure 2, or alternatively the current detector may have a separate outlet for the communication device 12'. In any case, the communication device 12' receives information on a situation where the power supply goes below or exceeds a predetermined limit value. The communication device may be configured to transmit this information onwards only when the power supply exceeds the limit value, only when it goes below the limit value, or in both cases each time the state changes (when the power supply changes from exceeding the limit value to going below the limit value, or vice versa). The information is transmitted by the communication device via a telecommunication connection by utilizing a predetermined message. If, for instance, a communication device 12' formed of a radio transmitter of a cellular radio system is involved, the communication device may transmit a predetermined message with radio signals. Alternatively, the device may be a communication device utilizing wireless communication, in which case the communication device transmits the message by utilizing a wireless connection.

The communication device may be arranged to transmit a message to, for example, the person responsible for the maintenance of the power supply point. Thus, the person responsible for the maintenance obtains information on an error condition, for instance, and may take measures to correct the error before the error causes detrimental effects, for instance the battery of an electric car not being charged. Alternatively, the communication device may be arranged to transmit a message about an error condition, for example, to a consumer, i.e. in the case of charging an electric car, to the driver of the electric car, for example to his/her mobile phone. Thus, the consumer is informed about the error at an early stage.

At a single power supply point, there is no need for both a signal light 10 and a communication device 12' in all embodiments but it may suffice in practical implementation that only one of them is in use.

It is to be understood that the above description and the related figures are only intended to illustrate the present invention. It will be obvious to a person skilled in the art that the invention can be modified and changed in other ways as well without deviating from the scope of the invention.

## Claims

1. A power supply point (1, 1') comprising
a power output (2) via which the power supply point is connectable to power-consuming equipment (8), whereby the power output (2) consists of a socket for receiving a connector at the end of a cable, or of a cable fixedly attached to the power supply point, one end of the cable being connectable to a connector in the power-consuming equipment; and
a supply cable (5) which connects the power output to an electric network to electrify the power output (2); **characterized in that** the power supply point (1, 1') further comprises:
a current detector (9) which monitors the power supply via the supply cable (5) to the power output (2); and
an indicating device (10, 12') which is responsive to the current detector (9) and which indicates at least a situation where the current goes below a predetermined limit value or where the current exceeds a predetermined limit value.

2. A power supply point (1, 1') according to claim 1, **characterized in that** said power supply point is enclosed in an outdoor installation housing (4) which protects the equipment installed in the outdoor installation housing against water and dirt.

3. A power supply point according to claim 1 or 2, **characterized in that** said power supply point (1, 1') is arranged in connection with a parking area to supply power via the power output (2) to a vehicle (3) parked in the parking area.

4. A power supply point (1, 1') according to any one of claims 1 to 3, **characterized in that** said indicating device (10) is formed of a signal light.

5. A power supply point (1, 1') according to any one of claims 1 to 4, **characterized in that** said indicating device (12') is formed of a communication device which executes indication of said situation by transmitting a predetermined message via a telecommunication connection.

6. A power supply point (1') according to claim 5, **characterized in that** said communication device is formed of a cellular radio system transmitter which transmits said message with radio signals.

7. A power supply point (1, 1') according to any one of claims 1 to 6, **characterized in that** said limit value is set to be lower than the idle running consumption of a battery charger (8) of the vehicle (3).

8. A power supply point (1, 1') according to claim 7, **characterized in that** the limit value is 10 mA or lower.

9. A power supply point (1, 1') according to any one of claims 1 to 6, **characterized in that** said limit value is set to be lower than the consumption of the vehicle's block heater and/or interior heater.
